(19) Europäisches Patentamt

European Patent Office

Office européen des brevets

(11) **EP 2 854 043 A1**

(12) **EUROPEAN PATENT APPLICATION**

(43) Date of publication:
01.04.2015 Bulletin 2015/14

(51) Int Cl.:
*G06F 17/10* (2006.01)     *G06F 17/18* (2006.01)

(21) Application number: 13306313.1

(22) Date of filing: 26.09.2013

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(71) Applicant: ALCATEL LUCENT
92100 Boulogne-Billancourt (FR)

(72) Inventors:
• Costantini, Carlo
20059 VIMERCATE (MB) (IT)

• Gavioli, Giancarlo
20059 VIMERCATE (MB) (IT)

(74) Representative: Pietra, Giulia et al
Marchi & Partners S.r.l.
Via G.B. Pirelli, 19
I-20124 Milano (IT)

Remarks:
Amended claims in accordance with Rule 137(2) EPC.

(54) **Digital circuit for slope filtering**

(57) It is disclosed a digital circuit for implementing a slope filtering on a sequence of data samples equally spaced in time, said slope filtering comprising calculating a linear combination:

$$\beta = \sum_{k=0}^{N-1} \beta_k y_k$$

of N consecutive data samples y0, y1, ... yN-1. The digital circuit has a transfer function H(z) equal to a Z-transform of the above linear combination, divided by $(1-z^{-1})^2$ and multiplied by $(1-z^{-1})^2$. The transfer function H(z) in particular has a denominator $(1-z^{-1})^2$ implemented by two cascaded integrators of the circuit, and a nominator that comprises a single multiplication by (N-1) implemented by a corresponding multiplier of the circuit. No other multipliers are required. The number of multipliers of the circuit is accordingly minimized and is independent of the number N. This makes the circuit simple, inexpensive and particularly suitable for noisy applications which require high values of N.

Figure 1

EP 2 854 043 A1

**Description**

**Technical field**

The present invention generally relates to the field of digital signal processing. More particularly, the present invention relates to a digital circuit for implementing a slope filtering on a sequence of equally spaced data samples, in particular data samples equally spaced in time.

**Background art**

As it is known, given a set of data samples $(x_0, y_0), (x_1, y_1), \ldots (x_{N-1}, y_{N-1})$, a linear regression is a statistical operation consisting in calculating the best linear fit of such set of samples, namely in finding the straight line:

$$y = \alpha + \beta x \qquad\qquad [1$$

which better approximates the distribution of data samples. In equation [1], $\alpha$ is the y-intercept and $\beta$ is the slope of the line. The y-intercept $\alpha$ and slope $\beta$ are typically calculated using the least square method, that provides the following equations:

$$\alpha = \frac{\left(\sum_{k=0}^{N} y_k\right)\left(\sum_{k=0}^{N} x_k^2\right) - \left(\sum_{k=0}^{N} x_k\right)\left(\sum_{k=0}^{N} x_k y_k\right)}{N\left(\sum_{k=0}^{N} x_k^2\right) - \left(\sum_{k=0}^{N} x_k\right)^2} \qquad\qquad [2]$$

and

$$\beta = \frac{N\left(\sum_{k=0}^{N} x_k y_k\right) - \left(\sum_{k=0}^{N} x_k\right)\left(\sum_{k=0}^{N} y_k\right)}{N\left(\sum_{k=0}^{N} x_k^2\right) - \left(\sum_{k=0}^{N} x_k\right)^2}. \qquad\qquad [3]$$

In case the independent variable x is time, the slope $\beta$ basically represents an average time derivative of the N data samples $(x_0, y_0), (x_1, y_1), \ldots (x_{N-1}, y_{N-1})$. Hence, assuming to acquire a theoretically infinite sequence of consecutive data samples, a time derivative of the data sample sequence may be estimated in real time by applying equation [3] to the N last acquired data samples, when a new sample is acquired. Such calculation will be termed herein after "slope filtering".

Slope filtering has many applications, including digital communications where it is used e.g. for carrier recovery circuits to estimate the frequency offset and drift between clock oscillators of transmitter and receiver, in circuits for estimation of signal rate, signal transition and transition-polarity detection, in circuits for estimating chromatic dispersion in digital coherent receivers, and so on. Besides digital communications, slope filtering may be applied also to other scenarios, such as controllers for industrial processes (e.g. in PID controllers) and, more generally, to any scenario where a time derivative of samples continuously acquired in time at a certain rate shall be estimated in real time.

"Slope filtering: FIR approach to linear regression" by Clay S. Turner, IEEE Signal Processing Magazine, November 2008, pages 159-163 discloses a time-domain slope filtering method which consists in calculating the slope $\beta$ by means of a FIR filter. In particular, under the assumption that the data samples $(x_0, y_0), (x_1, y_1) \ldots (x_{N-1}, y_{N-1})$ are consecutive and equally spaced in time (namely if $x_K = x_0 + k$ with k=0, 1, 2, ... N-1, which is the case in most applications), equation [3] may be rewritten as:

$$\beta = \sum_{k=0}^{N-1} \beta_k y_k , \qquad\qquad [4]$$

where:

$$\beta_k = \frac{12 \cdot k - 6(N-1)}{N(N^2 - 1)} . \qquad\qquad [5]$$

The slope $\beta$ therefore basically is a linear combination of the data sample values $y_0$, $y_1$, ... $y_{N-1}$. Equation [4] may be accordingly implemented as a FIR (Finite Impulsive Response) filter with N stages, whose coefficients $\beta_k$ are provided by equation [5]. The coefficients $\beta_k$ provided by equation [5] form a ramp (namely, they vary linearly with k) and are symmetric relative to (N-1)/2, namely $\beta_0 = -\beta_{N-1}$, $\beta_1 = -\beta_{N-2}$, etc. Therefore, instead of a N-stage filter, a "folded" FIR filter with N/2 stages may be used.

## Summary of the invention

The inventors have noticed that use of a FIR filter for implementing slope filtering is disadvantageous in that such filter comprises a number of multipliers dependent from N, namely from the number of consecutive data samples which are taken into account for calculating each value of the slope $\beta$.

Indeed, in most applications (in particular in digital communication applications) data samples are likely to be affected by a remarkable noise. In order to mitigate the detrimental effects of noise affecting single data samples onto the slope calculation, equation [4] shall be applied to a large number N of consecutive data samples. This however entails use of a FIR filter with a high number of multipliers, which is undesirable because multipliers represent the most complex and expensive elements of a digital circuit. Hence, in order to control the complexity and cost of a digital circuit, the number of multipliers which it comprises shall be minimized.

In view of the above, the inventors have tackled the problem of providing a method and digital circuit for implementing a slope filtering on a sequence of equally spaced data samples, which overcomes the aforesaid drawback, namely wherein the number of multipliers is minimized and independent of the number N of consecutive data samples which are taken into account for calculating each value of the slope $\beta$.

According to an aspect, there is provided a digital circuit for implementing a slope filtering on a sequence of data samples equally spaced in time, the slope filtering comprising calculating a linear combination according to the above equation [4] of N consecutive data samples (y0, y1, ... yN-1) of the sequence of data samples, wherein the digital circuit has a transfer function H(z) equal to the Z-transform $H_{FIR}(z)$ of the linear combination according to equation [4], divided by $(1-z^{-1})^2$ and multiplied by $(1-z^{-1})^2$.

Preferably, the numerator of the transfer function H(z) comprises a multiplication by (N-1), the circuit comprising a first multiplier suitable for implementing the multiplication by (N-1).

According to particularly preferred embodiments, (N-1) is a power of 2 and the first multiplier comprises a shift register.

Preferably, the circuit further comprises a first integrator a second integrator cascaded with the first integrator, the first and second integrators being suitable for implementing two consecutive divisions by $(1-z^{-1})$.

According to a first embodiment, the digital circuit further comprises a circuit portion cascaded with the first and second integrators and having a transfer function corresponding to a numerator of the transfer function H(z).

Preferably, such circuit portion comprises:

- a differentiator comprising a delay line and an adder connected in a feed-forward configuration, the differentiator being connected to an output of the second integrator;
- the first multiplier connected to an output of the differentiator;
- a second multiplier configured to multiply its input by 2 and connected to an output of the delay line of the differentiator;
- a third multiplier configured to multiply its input by 2 and connected to the output of the second integrator;
- a further adder connected to an output of the first multiplier and to an output of the third multiplier;
- a further delay line suitable for delaying its input by N clock cycles and connected to an output of the further adder; and
- a still further adder connected to an output of the further delay line, to the output of the first multiplier and to an output of the second multiplier.

According to a second embodiment, the circuit further comprises:

- the first multiplier connected to an output of the first integrator;
- a second multiplier configured to multiply its input by 2 and connected to an output of a delay line of the second integrator;
- a third multiplier configured to multiply its input by 2 and connected to an output of the second integrator;
- an adder connected to an output of the first multiplier and to an output of the third multiplier;
- a further delay line suitable for delaying its input by N clock cycles and connected to an output of the further adder; and
- a still further adder connected to an output of the further delay line, to the output of the first multiplier and to an output of the second multiplier.

Preferably, all components of the digital circuit are configured to operate at a same frequency $f_{IN}$.

According to a variant, the digital circuit further comprises at least one down-sampler located at an intermediate position of the circuit, the at least one down-sampler being configured to decimate its input thereby outputting a single value every X clock cycles, X being $1 < X \leq N$.

Preferably, components of the circuit located upstream the at least one down-sampler are configured to operate at a first frequency $f_{IN}$, and components of the circuit located downstream the at least one down-sampler are configured to operate at a second frequency lower than the first frequency $f_{IN}$.

Preferably, the circuit comprises adders and multipliers configured to implement modular arithmetic operations.

## Brief description of the drawings

The present invention will become clearer by reading the following detailed description, given by way of example and not of limitation, to be read by referring to the accompanying drawings, wherein:

- Figure 1 shows a digital circuit according to a first embodiment of the present invention;
- Figure 2 shows a digital circuit according to a second embodiment of the present invention; and
- Figure 3 shows a digital circuit according to a variant of the second embodiment.

## Detailed description of preferred embodiments of the invention

An N-stage FIR filter implementing the slope filtering calculation according to equation [4] using the coefficients $\beta_k$ provided by equation [5] has a transfer function equal to the Z-transform of equation [4], namely:

$$H_{FIR}(z) = \sum_{k=0}^{N-1} \frac{6(N-1) - 12 \cdot k}{N(N^2 - 1)} z^{-k} , \qquad [6]$$

namely:

$$H_{FIR}(z) = \frac{6}{N(N^2 - 1)} \cdot \sum_{k=0}^{N-1} (N - 1 - 2k) z^{-k} . \qquad [7]$$

Hence, $\beta_k = (N-1-2k)$, except the scaling factor $F = \dfrac{6}{N(N^2 - 1)}$ .

It shall be noticed that, since - as mentioned above - the coefficients $\beta_k$ provided by equation [5] and rewritten in equation [7] are symmetric relative to (N-1)/2 (namely $\beta_0 = -\beta_{N-1}$, $\beta_1 = -\beta_{N-2}$, etc.), the FIR transfer function $H_{FIR}(z)$ has a zero at z=1 (namely, at $\omega$=0).

The inventors have noticed that, by multiplying and dividing the FIR transfer function $H_{FIR}(z)$ according to equation [7] by $(1-z^{-1})^2$, the following transfer function H(z) is obtained:

$$H(z) = \frac{(1-z^{-1})^2}{(1-z^{-1})^2} \cdot H_{FIR}(z) = \frac{(1-z^{-1})^2}{(1-z^{-1})^2} \cdot F \cdot \sum_{k=0}^{N-1} (N-1-2k) \, z^{-k} =$$

$$= F \cdot \frac{(N-1)-(N+1)z^{-1}+(N+1)z^{-N}-(N-1)z^{-N+1}}{(1-z^{-1})^2}. \qquad [8]$$

It can be noticed that the operation of multiplying $H_{FIR}(z)$ by $(1-z^{-1})^2$ corresponds to applying a second derivative operation to the transfer function $H_{FIR}(z)$ and introduces a double zero of the transfer function $H(z)$ at z=1.

On the other hand, the operation of dividing $H_{FIR}(z)$ by $(1-z^{-1})^2$ corresponds to applying a double integral to the transfer function $H_{FIR}(z)$ and introduces a double pole of the transfer function $H(z)$ at z=1.

Therefore, $H(z)$ has a double pole at z=1 (due to double integral of $H_{FIR}(z)$) and a triple zero at z=1 (namely, a zero of $H_{FIR}(z)$ and a double zero due to second derivative of $H_{FIR}(z)$). This advantageously contributes to guarantee that a digital circuit having transfer function $H(z)$ is functionally equivalent to a known FIR filter having transfer function $H_{FIR}(z)$, as it will be discussed in detail herein after.

The numerator of equation [8] may also be rewritten as follows:

$$H(z) = F \cdot \frac{((N-1)\cdot(1-z^{-1})+2)\cdot(1+z^{-N})-2\cdot(1+z^{-1})}{(1-z^{-1})^2}. \qquad [9]$$

It can be noticed that equation [9] comprises a particularly reduced number of multiplications, which is independent from N. In particular, such multiplications (which are all included in the numerator of equation [9]) comprise a multiplication by (N-1) and two multiplications by 2. Since, within the context of digital signal processing, a multiplication by 2 actually is a scaling which may be implemented by a shift register (and not by a multiplier), the transfer function $H(z)$ of equation [9] may be implemented by a digital circuit which comprises a single multiplier by (N-1) (plus an optional multiplier by the scaling factor F, which is a constant factor and which accordingly may be merged in another circuit of the system in which slope calculation is implemented, e.g. in an ADC gain, a unit conversion factor, etc.), as it will be described in detail herein after.

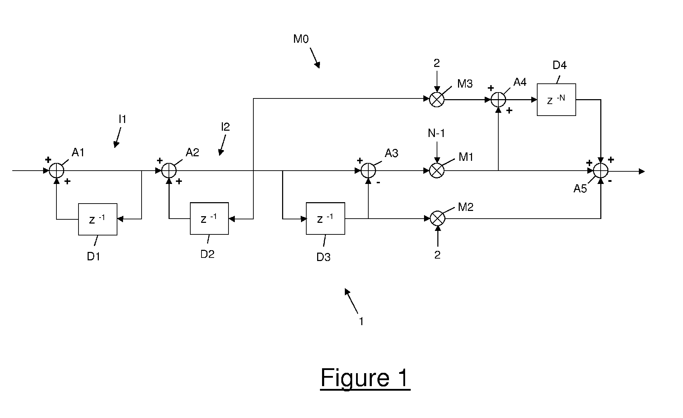

Figure 1 shows a digital circuit 1 having the transfer function $H(z)$ of equation [9], according to a first embodiment of the present invention.

The digital circuit 1 comprises four delay lines D1, D2, D3, D4, five adders A1, A2, A3, A4, A5 and three multipliers M1, M2, M3.

A first adder A1 and a first delay line D1 (suitable for delaying input values by 1 clock cycle) are connected in a feedback configuration so as to form a first integrator I1. Similarly, a second adder A2 and a second delay line D2 (suitable for delaying input values by 1 clock cycle) are also connected in a feedback configuration so as to form a second integrator I2 cascaded with the first integrator I1.

The other elements of the digital circuit 1 are reciprocally interconnected so as to form an all-zero module M0 (namely, a module whose transfer function has only zeros and no poles) cascaded with the two integrators I1, I2. In particular, a third delay line D3 (suitable for delaying input values by 1 clock cycle) and a third adder A3 are connected in a feed-forward configuration, thereby forming a differentiator. The output of the third adder A3 is connected to a first multiplier M1, which is configured to multiply its input by (N-1). The output of the third delay line D3 is also connected to a second multiplier M2, which is configured to multiply its input by 2. The output of the second integrator I2 is also connected to a third multiplier M3, which is configured to multiply its input by 2. Both the outputs of the first multiplier M1 and third multiplier M3 are connected to a fourth adder A4. The output of the fourth adder A4 is in turn connected to a fourth delay line D4 suitable for delaying input values by N clock cycles. The outputs of the first multiplier M1, second multiplier M2 and fourth delay line D4 are connected to a fifth adder A5. It can be noticed that the transfer function of the all-zero module M0 is:

$$H_{M0}(z) = (N-1)\cdot(1-z^{-1})+[(N-1)\cdot(1-z^{-1})+2]\cdot z^{-N}-2\cdot z^{-1} \qquad [10]$$

Through simple algebraic steps, it can be easily derived that $H_{M0}(z)$ corresponds to the numerator of equation [9].

Therefore, advantageously, the digital circuit 1 implements slope filtering according to equation [9] through a very reduced number of multipliers. In particular, the digital circuit 1 comprises only three multipliers: the multiplier M1 by (N-1) and two multipliers M2 and M3 by 2. As mentioned above, the multipliers M2 and M3 by 2 may be implemented as shift registers. Hence, the circuit 1 actually comprises a single multiplier, namely M1. Moreover, if (N-1) is a power of 2, also the multiplier M1 may be implemented as a shift register. In such case, the digital circuit 1 does not comprise any multiplier at all. The digital circuit 1 has accordingly a very reduced cost and complexity.

Moreover, the cost and complexity of the circuit 1 is advantageously independent of N, namely of the number of consecutive data samples which are taken into account for calculating each value of the slope $\beta$. The number N may accordingly be set to very high values. Hence, the digital circuit 1 implementing the slope filtering according to equation [9] is particularly advantageous for applications wherein data samples are affected by a relevant noise, whose detrimental effects on the slope filtering calculation shall be mitigated by performing the calculation on a large number N of consecutive data samples.

The digital circuit 1 is advantageously equivalent to a FIR filter from every functional point of view.

In particular, although the digital circuit 1 comprises two integrators I1, I2 at its input (which indefinitely cumulate the values $y_0$, $y_1$, ... $y_{N-1}$ of the input data samples), similarly to a FIR filter the value of each sample affects the circuit output (namely, the calculated value of the slope $\beta$) for a finite number of clock cycles, namely N clock cycles. Therefore, in case of a sample affected by a particularly strong noise or in case of an anomalous event temporarily altering the value stored in one or more registers of the circuit 1, the detrimental effect of this situation is automatically reset after expiration of a transient of N clock cycles. Similarly, the initial conditions of the registers of the circuit cease to produce their effects after N clock cycles. This is due to the fact that an anomalous value of an input sample or a register of the circuit 1 basically can be seen as a constant added to the signal after the double integrator I1, I2. However, the double integrator I1, I2 is followed by the all-zero module M0 which has a triple zero in z=1, two zeros being cancelled by the two poles of the double integrator and the third one filtering out any constant component ($\omega$=0) of the signal.

Furthermore, although it comprises two integrators I1, I2 at its input (which indefinitely cumulate the values of the input samples), the digital circuit 1 may be designed so that it does not overflow. Indeed, assuming that the values $y_0$, $y_1$, ... $y_{N-1}$ of the input data samples are comprised in the range [-1; 1], the output of the digital circuit 1 (namely the slope $\beta$) is limited as follows:

$$|\beta| \le \sum_{k=0}^{N-1} |(2k-N+1)| = \begin{cases} \dfrac{N^2}{2} \text{ if N even,} & \dfrac{N^2-1}{2} \text{ if N odd} \end{cases} \qquad [11]$$

Therefore, if Bin is the size in bits of the digitalized values $y_0$, $y_1$, ... $y_{N-1}$ of the data samples at the input of the circuit 1, the size in bits of the digitalized values of the slope $\beta$ calculated at the output of the circuit 1 is

$$\text{Bout} = \text{Bin} + \log_2 (N^2/2). \qquad [12]$$

If the adders and multipliers of the circuit 1 are design to implement modular arithmetic operations (namely, in two's complement format with Bout bits), when a multiplication or an addition is calculated, only the Bout least significant bits are considered, the exceeding ones being disregarded. This advantageously bounds the output of the circuit 1 in the range [$-2^{\text{Bout-1}}$; $2^{\text{Bout-1}}$ -1]. The error introduced by disregarding the exceeding bits in the integrators I1, I2 is cancelled by the differentiating operations implemented by the all-zero module M0. Also such differentiating operations are indeed modular, and therefore inherently eliminate possible spikes due to discontinuities affecting the sequence of values output by the integrators I1, I2 and being introduced by the modular operations performed by the adders A1, A2.

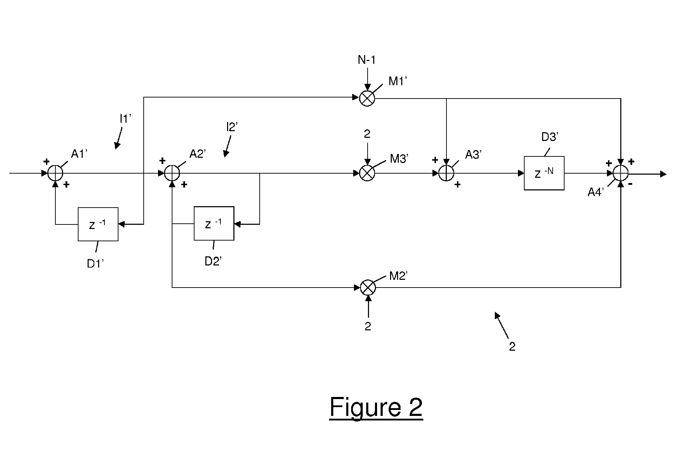

Figure 2 shows a digital circuit 2 having the transfer function H(z) of equation [9], according to a second embodiment of the present invention.

The digital circuit 2 comprises three delay lines D1', D2', D3', four adders A1', A2', A3', A4' and three multipliers M1', M2', M3'.

A first adder A1' and a first delay line D1' (suitable for delaying input values by 1 clock cycle) are connected in a feedback configuration so as to form a first integrator I1'. Similarly, a second adder A2' and a second delay line D2' (suitable for delaying input values by 1 clock cycle) are also connected in a feedback configuration so as to form a second integrator I2' cascaded with the first integrator I1'.

The output of the first integrator I1' is connected to a first multiplier M1', which is configured to multiply its input by N-1. Besides, the output of the second delay line D2' is connected to a second multiplier M2', which is configured to multiply its input by 2. The output of the second integrator I2' is instead connected to third multiplier M3', which is configured to multiply its input by (N-1). Both the outputs of the first multiplier M1' and third multiplier M3' are connected to a third adder A3', whose output is in turn connected to a third delay line D3' suitable for delaying input values by N clock cycles. The outputs of the first multiplier M1', second multiplier M2' and third delay line D3' are connected to a fourth adder A4'. It can be noticed that the transfer function of circuit 2 is as follows:

$$H'(z) = \frac{1}{1-z^{-1}} \cdot \left\{ (N+1) + \left[ \frac{2}{1-z^{-1}} + (N-1) \right] \cdot z^{-N} - \frac{2z^{-1}}{1-z^{-1}} \cdot z^{-1} \right\} \qquad [13]$$

Through simple algebraic steps, it can be easily derived that H'(z) corresponds to H(z) of equation [9]. Hence, the circuit 2 of Figure 2 is equivalent to the circuit 1 of Figure 1 from the functional point of view. The considerations about overflows and initial conditions discussed above with reference to circuit 1 therefore apply also to circuit 2.

From the structural point of view, the circuit of Figure 2 is instead advantageously even simpler than circuit 1, in that it comprises a reduced number of components (in particular, three delay lines instead of four delay lines). The digital circuit 2 according to the second embodiment is accordingly even simpler and less costly than circuit 1.

Both the digital circuit 1 and the digital circuit 2 described herein after are suitable for calculating values of the slope β on a sliding window of N input digital samples, and for providing one value of the slope β at each clock cycle (namely, at each translation of the sliding window by one sample). Hence, in such circuits, all the elements operate at a same frequency $f_{IN}$, which is the rate at which the sample values $y_k$ are fed to the circuit.

However, for some applications, it might be desirable providing only one value of the slope β every X clock cycles (1 < X ≤ N). This allows calculating the values of the slope β only for non-overlapping, contiguous time windows (X=N) or for time windows having a predefined overlap larger that a single sample (1<X<N).

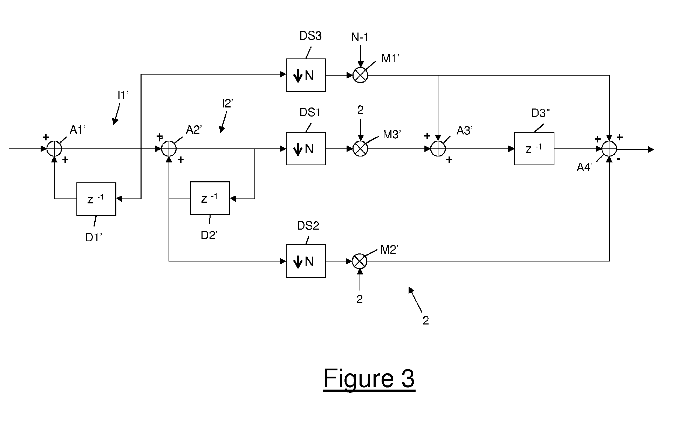

Figure 3 shows a variant of the digital circuit of Figure 2, which provides a decimated output, in particular provides one value of the slope β every X=N clock cycles.

In principle, such decimation could be implemented by a down-sampler provided at the output of the circuit of Figure 2 and selecting one calculated value of the slope β every N calculated ones. This way, however, N-1 values every N ones would be needlessly calculated.

According to the variant shown in Figure 3, instead of a single down-sampler at the output of the circuit, three down-samplers DS1, DS2 and DS3 are provided within the circuit 2, in particular immediately before the multipliers M1', M2' and M3'. Therefore, suddenly after integrations carried out by the integrator I1' and/or I2', the down-samplers M1', M2' and M3' select one input value every N ones (namely, every N clock cycles). This allows a reduction by a factor N of the operating frequency of the elements located downstream the down-samplers, namely the multipliers M1', M2', M3', the adders A3', A4' and the delay line D3'.

Hence, while the integrators I1', I2' continue operating at the operating frequency $f_{IN}$, the rest of the circuit advantageously operates at a must reduced frequency, namely $f_{IN}/N$. In particular, the delay line D3' that, according to the second embodiment shown in Figure 2, is configured to delay each received input value by N clock cycles (each clock cycle being $1/f_{IN}$), according to such variant is replaced by a delay line D3" configured to delay each received input value by a single clock cycle, the clock cycle of the delay line D3" being now $N/f_{IN}$.

Hence, according to such advantageous variant, the circuit of Figure 3 is simpler than the circuit of Figure 2 with output down-sampler, the components located downstream the down-sampler being simpler than the corresponding ones in the non-decimated circuit.

Similar considerations apply for variants suitable for providing one value of the slope β every X<N clock cycles. According to such variants, in particular, the delay line D3' delaying by N clock cycles is replaced by two simpler cascaded delay lines, one for delaying by 1 clock cycle and one for delaying by N-X clock cycles.

Hence, while being functionally equivalent to a FIR filter suitable for implementing slope filtering, the digital circuits according to embodiments of the present invention are advantageously much simpler than a FIR filter from a structural viewpoint. While indeed a FIR filter configured to implement slope filtering on N samples comprises N multipliers (or N/2, in case a folded structure is used), the above described circuits comprise a much lower number of multipliers, which moreover is independent of N. Such digital circuits have accordingly a very reduced cost and complexity, independently of the value of N. These features make the digital circuits of the present invention particularly advantageous for applications wherein slope filtering shall be performed on a particularly high number N of samples.

**Claims**

1. A digital circuit (1; 2) for implementing a slope filtering on a sequence of data samples equally spaced in time, said slope filtering comprising calculating a linear combination:

$$\beta = \sum_{k=0}^{N-1} \beta_k y_k$$

of N consecutive data samples ($y_0$, $y_1$, ... $y_{N-1}$) of said sequence of data samples, said digital circuit (1; 2) having a transfer function H(z) equal to a Z-transform $H_{FIR}(z)$ of said linear combination, divided by $(1-z^{-1})^2$ and multiplied by $(1-z^{-1})^2$.

2. The digital circuit (1; 2) according to claim 1, wherein a numerator of said transfer function H(z) comprises a multiplication by (N-1), said circuit (1; 2) comprising a first multiplier (M1, M1') suitable for implementing said multiplication by (N-1).

3. The digital circuit (1; 2) according to claim 2, wherein (N-1) is a power of 2 and said first multiplier (M1, M1') comprises a shift register.

4. The digital circuit (1; 2) according to claim 2 or 3, wherein said circuit (1; 2) further comprises a first integrator (I1; I1') and a second integrator (I2; I2') cascaded with said first integrator (I1'; I1'), said first and second integrators (I1, I2; I1', I2') being suitable for implementing two consecutive divisions by $(1-z^{-1})$.

5. The digital circuit (1; 2) according to claim 4, wherein it further comprises a circuit portion (M0) cascaded with said first and second integrators (I1, I2) and having a transfer function corresponding to a numerator of said transfer function H(z).

6. The digital circuit (1; 2) according to claim 5, wherein said circuit portion (M0) comprises:

   - a differentiator (D3, A3) comprising a delay line (D3) and an adder (A3) connected in a feed-forward configuration, said differentiator (D3, A3) being connected to an output of said second integrator (I2);
   - said first multiplier (M1) connected to an output of said differentiator (D3, A3);
   - a second multiplier (M2) configured to multiply its input by 2 and connected to an output of said delay line (D3);
   - a third multiplier (M3) configured to multiply its input by 2 and connected to said output of said second integrator (I2);
   - a further adder (A4) connected to an output of said first multiplier (M1) and to an output of said third multiplier (M3);
   - a further delay line (D4) suitable for delaying its input by N clock cycles and connected to an output of said further adder (A4); and
   - a still further adder (A5) connected to an output of said further delay line (D4), to said output of said first multiplier (M1) and to an output of said second multiplier (M2).

7. The digital circuit (1; 2) according to claim 5, wherein said circuit (1; 2) further comprises:

   - said first multiplier (M1') connected to an output of said first integrator (I1');
   - a second multiplier (M2') configured to multiply its input by 2 and connected to an output of a delay line (D2') of said second integrator (I2');
   - a third multiplier (M3') configured to multiply its input by 2 and connected to said output of said second integrator (I2');
   - an adder (A3') connected to an output of said first multiplier (M1') and to an output of said third multiplier (M3');
   - a further delay line (D3') suitable for delaying its input by N clock cycles and connected to an output of said further adder (A3'); and
   - a still further adder (A4') connected to an output of said further delay line (D3'), to said output of said first multiplier (M1') and to an output of said second multiplier (M2').

8. The digital circuit (1; 2) according to any of the preceding claims, wherein all components of said digital circuit (1;

2) are configured to operate at a same frequency $f_{IN}$.

9. The digital circuit (1; 2) according to any of claims 1 to 7, wherein it further comprises at least one down-sampler (DS1, DS2, DS3) located at an intermediate position of said circuit (1; 2), said at least one down-sampler (DS1, DS2, DS3) being configured to decimate its input thereby outputting a single value every X clock cycles, X being 1 < X ≤ N.

10. The digital circuit (1; 2) according to claim 9, wherein components of said circuit (1; 2) located upstream said at least one down-sampler (DS1, DS2, DS3) are configured to operate at a first frequency $f_{IN}$, and components of said circuit (1; 2) located downstream said at least one down-sampler (DS1, DS2, DS3) are configured to operate at a second frequency lower than said first frequency $f_{IN}$.

11. The digital circuit (1; 2) according to any of the preceding claims, wherein said circuit (1; 2) comprises adders and multipliers configured to implement modular arithmetic operations.

**Amended claims in accordance with Rule 137(2) EPC.**

1. A digital circuit (1; 2) for implementing a slope filtering on a sequence of data samples equally spaced in time, said slope filtering comprising calculating a linear combination:

$$\beta = \sum_{k=0}^{N-1} \beta_k y_k$$

wherein:

$$\beta_k = \frac{12 \cdot k - 6(N-1)}{N(N^2 - 1)}$$

of N consecutive data samples ($y_0$, $y_1$, ... $y_{N-1}$) of said sequence of data samples, said digital circuit (1; 2) having a transfer function H(z) equal to a Z-transform $H_{FIR}(z)$ of said linear combination, divided by $(1-z^{-1})^2$ and multiplied by $(1-z^{-1})^2$, wherein said circuit (1; 2) comprises:

- a first integrator (I1; I1') and a second integrator (I2; I2') cascaded with said first integrator (I1; I1'), said first and second integrators (I1, I2; I1', I2') being suitable for implementing two consecutive divisions by $(1-z^{-1})$; and
- a circuit portion (M0) cascaded with said first and second integrators (I1, I2) and having a transfer function corresponding to a numerator of said transfer function H(z), wherein said numerator comprises a multiplication by (N-1) and two multiplications by 2, said circuit (1; 2) comprising a first multiplier (M1, M1') suitable for implementing said multiplication by (N-1), and a second multiplier (M2, M2') and a third multiplier (M3, M3') suitable for implementing said multiplications by 2.

2. The digital circuit (1; 2) according to claim 1, wherein (N-1) is a power of 2 and said first multiplier (M1, M1') comprises a shift register.

3. The digital circuit (1; 2) according to claim 1 or 2, wherein said circuit portion (M0) comprises:

- a differentiator (D3, A3) comprising a delay line (D3) and an adder (A3) connected in a feed-forward configuration, said differentiator (D3, A3) being connected to an output of said second integrator (I2);
- said first multiplier (M1) connected to an output of said differentiator (D3, A3);
- said second multiplier (M2) configured to multiply its input by 2 and connected to an output of said delay line (D3);
- said third multiplier (M3) configured to multiply its input by 2 and connected to said output of said second integrator (I2);
- a further adder (A4) connected to an output of said first multiplier (M1) and to an output of said third multiplier (M3);
- a further delay line (D4) suitable for delaying its input by N clock cycles and connected to an output of said further adder (A4); and
- a still further adder (A5) connected to an output of said further delay line (D4), to said output of said first multiplier (M1) and to an output of said second multiplier (M2).

4. The digital circuit (1; 2) according to claim 1 or 2, wherein said circuit (1; 2) further comprises:

- said first multiplier (M1') connected to an output of said first integrator (I1');
- said second multiplier (M2') configured to multiply its input by 2 and connected to an output of a delay line (D2') of said second integrator (I2');
- said third multiplier (M3') configured to multiply its input by 2 and connected to an output of said second integrator (I2');
- an adder (A3') connected to an output of said first multiplier (M1') and to an output of said third multiplier (M3');
- a further delay line (D3') suitable for delaying its input by N clock cycles and connected to an output of said further adder (A3'); and
- a still further adder (A4') connected to an output of said further delay line (D3'), to said output of said first multiplier (M1') and to an output of said second multiplier (M2').

5. The digital circuit (1; 2) according to any of the preceding claims, wherein all components of said digital circuit (1; 2) are configured to operate at a same frequency $f_{IN}$.

6. The digital circuit (1; 2) according to any of claims 1 to 4, wherein it further comprises at least one down-sampler (DS1, DS2, DS3) located at an intermediate position of said circuit (1; 2) after said first integrator (I1; I1') and/or said second integrator (I2; I2'), said at least one down-sampler (DS1, DS2, DS3) being configured to decimate its input thereby outputting a single value every X clock cycles, X being $1 < X \leq N$.

7. The digital circuit (1; 2) according to claim 6, wherein components of said circuit (1; 2) located upstream said at least one down-sampler (DS1, DS2, DS3) are configured to operate at a first frequency $f_{IN}$, and components of said circuit (1; 2) located downstream said at least one down-sampler (DS1, DS2, DS3) are configured to operate at a second frequency lower than said first frequency $f_{IN}$.

8. The digital circuit (1; 2) according to any of the preceding claims, wherein said circuit (1; 2) comprises adders and multipliers configured to implement modular arithmetic operations.

Figure 1

## Figure 2

Figure 3

Europäisches
Patentamt

European
Patent Office

Office européen
des brevets

# EUROPEAN SEARCH REPORT

Application Number

EP 13 30 6313

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MORGAN D R ET AL: "Nonuniform linear regression with block-wise sample-minimum preprocessing", IEEE TRANSACTIONS ON SIGNAL PROCESSING, vol. 58, no. 8, August 2010 (2010-08), pages 4040-4049, XP011307530, ISSN: 1053-587X | 1-8,11 | INV. G06F17/10 G06F17/18 |
| A | * sections I, II; equations (8), (10) * | 9,10 | |
| A | SCOTT L B ET AL: "Efficient methods for data smoothing", SIAM JOURNAL OF NUMERICAL ANALYSIS, vol. 26, no. 3, June 1989 (1989-06), pages 681-692, XP008171140, ISSN: 0036-1429 * pages 681-685 * | 1-11 | |
| A | BROMBA M U A ET AL: "Efficient computation of polynomial smoothing digital filters", ANALYTICAL CHEMISTRY, vol. 51, no. 11, September 1979 (1979-09), pages 1760-1762, XP055133838, ISSN: 0003-2700, DOI: 10.1021/ac50047a038 * the whole document * | 1-11 | |
| A,D | TURNER C: "Slope filtering: An FIR approach to linear regression", IEEE SIGNAL PROCESSING MAGAZINE, vol. 25, no. 6, November 2008 (2008-11), pages 159-163, XP011236248, ISSN: 1053-5888, DOI: 10.1109/MSP.2008.929816 * the whole document * | 1-11 | |

TECHNICAL FIELDS SEARCHED (IPC)

G06F
H03H

-/--

The present search report has been drawn up for all claims

| Place of search | Date of completion of the search | Examiner |
|---|---|---|
| Berlin | 14 August 2014 | Domingo Vecchioni, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 13 30 6313

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Lyons R G: "Understanding Digital Signal Processing - Third Edition", August 2012 (2012-08), Prentice Hall, XP055128413, pages 820-821, * section 13.44 * | 1-11 | |

-----

TECHNICAL FIELDS
SEARCHED        (IPC)

The present search report has been drawn up for all claims

| Place of search | Date of completion of the search | Examiner |
|---|---|---|
| Berlin | 14 August 2014 | Domingo Vecchioni, M |

CATEGORY OF CITED DOCUMENTS

X : particularly relevant if taken alone
Y : particularly relevant if combined with another
　document of the same category
A : technological background
O : non-written disclosure
P : intermediate document

T : theory or principle underlying the invention
E : earlier patent document, but published on, or
　after the filing date
D : document cited in the application
L : document cited for other reasons

& : member of the same patent family, corresponding
　document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CLAY S. TURNER.** Slope filtering: FIR approach to linear regression. *IEEE Signal Processing Magazine,* November 2008, 159-163